# EUROPEAN PATENT SPECIFICATION

(11) **EP 3 686 932 B1**
(45) Date of publication and mention of the grant of the patent: **21.01.2026**
(21) Application number: 18919397.2
(22) Date of filing: 20.11.2018
(51) Int. Cl.: H10F 39/12, H10K 59/65, G06V 40/13, H10F 39/00

(54) **IMAGE SENSOR AND RELATED HANDHELD APPARATUS**
BILDSENSOR UND ZUGEHÖRIGES HANDGERÄT
CAPTEUR D'IMAGE ET APPAREIL PORTATIF ASSOCIÉ

(43) Date of publication of application: 29.07.2020
(73) Proprietor: SHENZHEN GOODIX TECHNOLOGY CO., LTD., Shenzhen, Guangdong 518045 (CN)
(72) Inventor: CHAO, Wei-Min, Shenzhen, Guangdong 518045 (CN)
(74) Representative: Casalonga
(86) International application number: PCT/CN2018/116317
(87) International publication number: WO 2020/102959

(56) References cited:
- CN-A- 103 456 683
- CN-A- 103 855 177
- CN-A- 106 373 973
- CN-A- 108 496 180
- US-A1- 2010 243 868
- US-A1- 2017 220 844
- US-A1- 2018 301 494

## Description

### TECHNICAL FIELD

The present disclosure relates to image sensors and, more particularly, to an image sensor conducive to reduction of optical cross-talk and an associated handheld device.

### BACKGROUND

Semiconductor image sensors are for use in sensing light waves. However, image sensors generate interference signals, for example, optical cross-talk, between adjacent pixels, to the detriment of performance of the image sensors. Furthermore, components at the periphery of the image sensors must be kept optically dark. When exposed to light, the components at the periphery not only manifest compromised performance but also generate interference signals.

Therefore, it is imperative to overcome the aforesaid drawback: when image sensors are applied to optical under-display fingerprint sensing technology, optical cross-talk affects their capability to sense fingerprints.

### SUMMARY OF THE INVENTION

One of the objectives of the present disclosure is to disclose an image sensor and an associated handheld device to solve the aforementioned issues.

An embodiment of the present disclosure discloses an image sensor according to claim 1.

An embodiment of the present disclosure discloses a handheld device. The handheld device includes: a display assembly; and an image sensor, including the image sensor described above, for obtaining fingerprint information of the specific subject.

According to the present disclosure, the image sensor and the handheld device demonstrate reduced optical cross-talk because the image sensor has a mask with an opening.

### BRIEF DESCRIPTION OF THE DRAWINGS

FIG. 1 is a cross-sectional view of an image sensor according to an embodiment of the present disclosure.
FIG. 2 is a partial enlarged view of the image sensor shown in the cross-sectional view of FIG. 1.
FIG. 3 is a top view of the image sensor shown in FIG. 1.
FIG. 4 is a cross-sectional view of an image sensor according to another embodiment of the present disclosure.
FIG. 5 is a schematic view of the image sensor for use with a handheld device according to an embodiment of the present disclosure.
FIG. 6 is a cross-sectional view of the handheld device according to an embodiment shown in FIG. 5.

### DETAILED DESCRIPTION OF THE EMBODIMENTS

Disclosed below are embodiments or examples illustrative of different features of the present disclosure. Specific examples of components described hereunder and configurations thereof are intended to simplify the present disclosure. Understandably, the descriptions serve illustrative purposes only but are not intended to restrict the present disclosure. For instance, in the descriptions below, the expression "forming a first feature on or over a second feature" may mean that, in an embodiment, the first and second features are in direct contact, or may mean that, in another embodiment, additional components are formed between the first and second features such that the first and second features may not be in direct contact. Furthermore, for the sake of brevity and clarity, reference numerals and/or signs may be repeatedly used in embodiments of the present disclosure without indicating any relationship between different embodiments and/or aspects.

Position-related terms, such as "under", "below", "lower", "over", "on", and the like, are used hereunder to describe the position of a component or feature relative to another or a plurality of components or features in the accompanying drawings. In addition to relative positions in the drawings, the position-related terms indicate different directions in which a device is located when it is in use or operated. The described device may be disposed in other directions (for example, rotated by 90 degrees or in other directions). These position-related terms should be explained correspondingly.

Although all the numerical ranges or parameters disclosed in the present disclosure are approximations, the numerical ranges or parameters express related numerical values in specific embodiments as precisely as possible. However, intrinsically, every numerical value inevitably comes with a standard deviation which arises from a testing method. The adverb "approximately" used hereunder means that the difference between the actual numerical value and a specific numerical value is less than 10%, 5%, 1% or 0.5%. Alternatively, the adverb "approximately" used hereunder means that the actual numerical value differs from the mean by a standard deviation or less, and the standard deviation is defined by persons skilled in the art. Understandably, except for empirical embodiments, or unless otherwise specified, all numerical ranges, quantity, numerical values, and percentages (for example, descriptive of the amount of a material used, time period, temperature, operation conditions, quantitative proportion, and the like) used hereunder are approximations. Therefore, unless otherwise specified, all numerical values of parameters disclosed hereunder are approximations and are subject to changes as needed. At the very least, the numerical values of parameters must be interpreted as numerical values characterized by specific significant figures and obtained by a general carry system. In this regard, a numerical value range is expressed as starting from an endpoint and ending at another endpoint or as lying between two endpoints. Unless otherwise specified, every numerical value range includes endpoints.

The image sensor of the present disclosure reduces optical cross-talk. When applied to optical under-display fingerprint sensing technical, the image sensor of the present disclosure renders acquired fingerprint information more accurate and effectively enhances the reliability of optical under-display fingerprint sensing. The image sensor and the associated handheld device, as provided by the present disclosure, are hereunder illustrated by plurality of embodiments, depicted by the accompanying drawings, and described below.

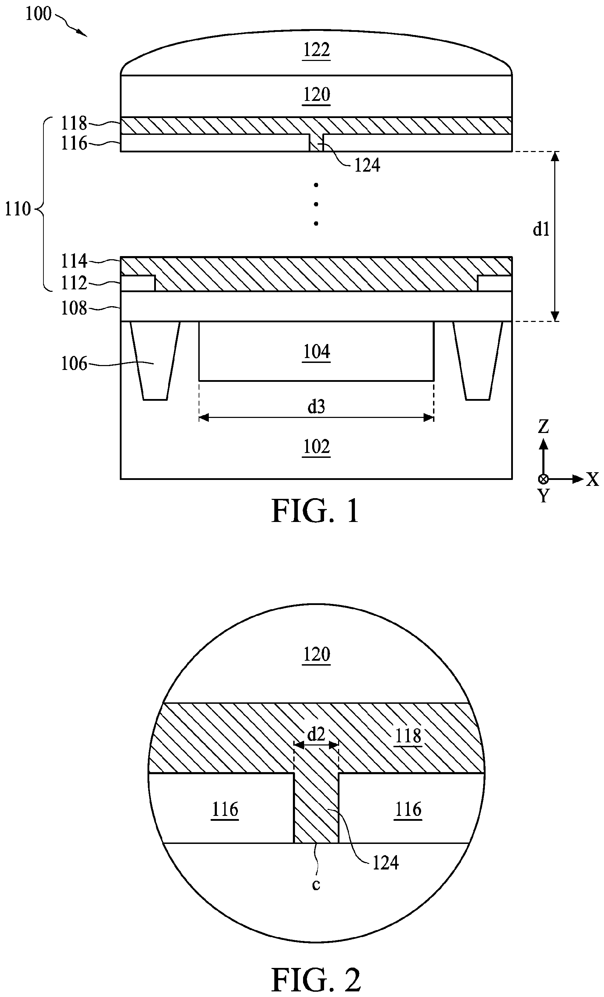

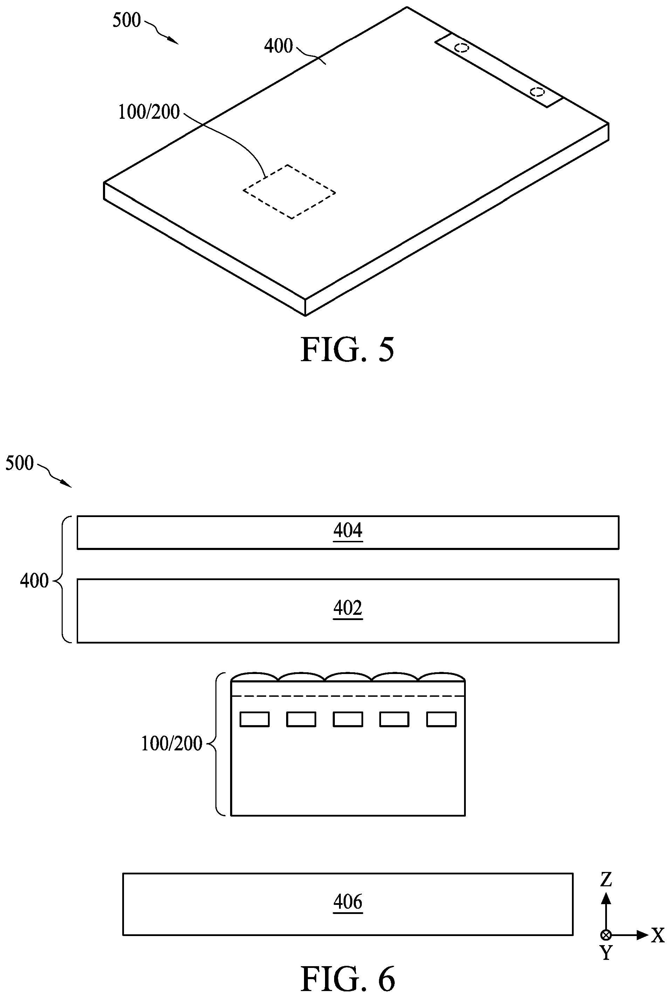

Referring to FIG. 1, there is shown a cross-sectional view of an image sensor according to an embodiment of the present disclosure. Although an image sensor 100 shown in FIG. 1 has one pixel unit only, the image sensor 100 in practice can include a plurality of pixel units extending in x-axis direction and/or y-axis direction so as to be arranged in a matrix. The image sensor 100 has unlimited applications. In the embodiment illustrated by FIG. 5 and FIG. 6, the image sensor 100 performs optical under-display fingerprint sensing.

Particularly, in this embodiment, the image sensor 100 is a front-side-illuminated (FSI) CMOS image sensor. The image sensor 100 includes a substrate 102, a metal stacked layer 110, a filter 120 and a microlens 122. The substrate 102 is doped to a first conductivity type. For example, the substrate 102 is a silicon substrate which contains p-type dopants (for example, boron). The substrate 102 has a front side and a back side. The front side of the substrate 102 faces the microlens 122 and thus is irradiated by light waves. The backside is opposite to the front side. In a variant embodiment, a dielectric layer 108 is disposed between the metal stacked layer 110 and the substrate 102.

The substrate 102 includes a light collection region 104 and an isolation structure 106. The light collection region 104 is disposed in the substrate 102 and neighboring the front side of the substrate 102. In other words, the light collection region 104 extends from the front side of the substrate 102 toward the back side of the substrate 102 and does not extend to the back side of the substrate 102. The light waves admitted through the microlens 122 are converted by the light collection region 104 into photogenerated charge carriers. The light collection region 104 is doped to a second conductivity type opposite to the first conductivity type. For example, the light collection region 104 is a silicon layer which contains n-type dopants (for example, arsenic and phosphorus). However, understandably, the aforesaid conductivity types of all components are swappable, allowing the substrate 102 and the light collection region 104 to be n-doped and p-doped, respectively.

The isolation structure 106 is disposed around the light collection region 104. The isolation structure 106 is a shallow trench isolation (STI) structure. When the image sensor 100 includes a plurality of pixel units, the isolation structure 106 isolates adjacent pixel units from each other so as to reduce optical cross-talk.

The metal stacked layer 110 includes a plurality of metal layers (for example, 112, 116) and a plurality of inter-metal-layer dielectric layers (for example, 114, 118) disposed between the metal layers and corresponding to the metal layers, respectively. The inter-metal-layer dielectric layers are made of silicon oxide, silicon oxynitride according to an embodiment forming part of the claimed invention. Inter-metal-layer dielectric layers made from any material with low dielectric constant other than silicon oxide or silicon oxynitride are not forming part of the claimed invention. In this embodiment, the topmost metal layer 116 of the metal stacked layer 110 functions as a mask. The metal layer 116 has an opening 124. The dielectric layer 118 disposed between and corresponding to the metal layer 116. The inter-metal-layer dielectric layer corresponding to the metal layer where the mask is disposed extends to the opening 124 to fill the opening 124. The light waves admitted through the microlens 122 pass through the opening 124 to reach the light collection region 104 so as to be converted into the photogenerated charge carriers. In the metal stacked layer 110, all the metal layers under the metal layer 116 must not block the light waves. For example, none of the metal layers under the metal layer 116 overlaps the opening 124 from a top view. In a variant embodiment, none of the metal layers under the metal layer 116 overlaps the light collection region 104.

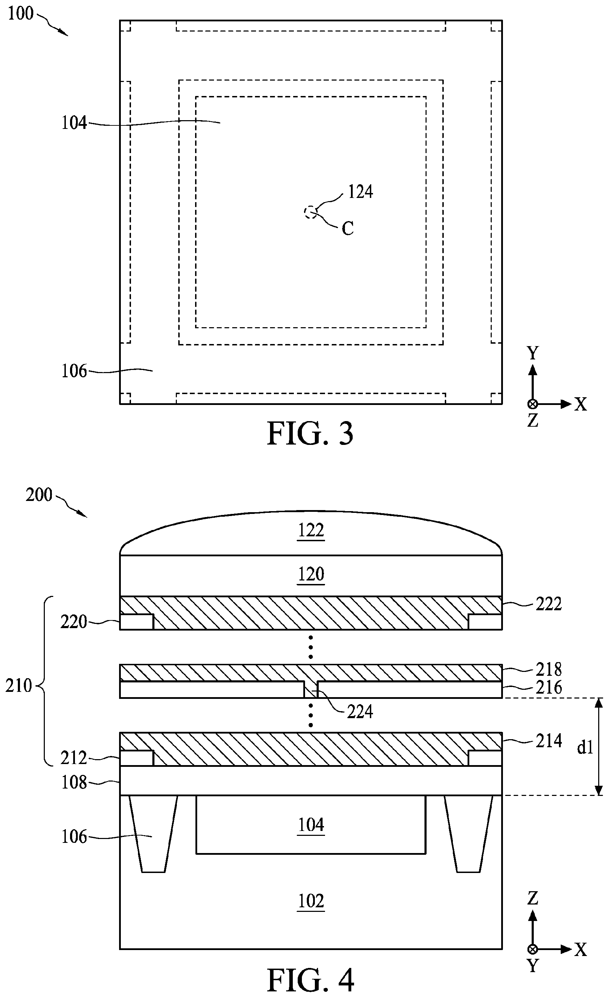

To further illustrate the structure of the image sensor 100, FIG. 2 and FIG. 3 provide schematic views of the image sensor 100. FIG. 2 is a partial enlarged view of the image sensor 100 shown in the cross-sectional view of FIG. 1. FIG. 3 is a top view of the image sensor 100 shown in FIG. 1. As shown in FIG. 2 and FIG. 3, the opening 124 overlaps the light collection region 104 from a top view, and, owing to the position of the opening 124 and a diameter d2 of the opening 124, the opening 124 does not extend beyond the light collection region 104. Therefore, from a top view, the metal layer 116 functions as a mask providing a complete shield except for part of the light collection region 104; in other words, the metal layer 116 shields the isolation structure 106 between adjacent pixel units. Optical interference between adjacent pixel units is prevented, because the metal layer 116 blocks most of the light waves (though the metal layer 116 permits some of the light waves to enter the light collection region 104 through the opening 124.)

In this embodiment, the opening 124 is substantially in a round shape, and the diameter d2 of the opening 124 is configured to bring about pinhole diffraction such that a diffraction pattern which manifests circular symmetry occurs when the light waves pass through the opening 124, and the central region of the diffraction pattern has greater brightness than the peripheral region of the diffraction pattern other than the central region. In this embodiment, center c of the opening 124 substantially overlaps the center of the light collection region 104, and thus the center of the diffraction pattern substantially overlaps the center of the light collection region 104. Hence, energy is concentrated at the center of the light collection region to thereby enhance the efficiency of photoelectric conversion.

In an embodiment, the size of the opening 124 is determined according to the wavelength of specific light waves. In the claimed embodiment of the invention, specific light waves have a wavelength of 526 nm to 606 nm, the diameter d2 of the opening 124 is 2.36 to 3.45 times greater than the wavelength of specific light waves. In a variant embodiment of the claimed invention, the size of the opening 124 is determined according to the size of the light collection region 104. This means the ratio of the diameter d2 of the opening 124 to width d3 of the light collection region 104 is 1 : 3.16 ~ 4.61. In a variant embodiment according to the claimed invention, the size of the opening 124 is determined according to a distance d1 between the light collection region 104 and the opening 124. This means the ratio of the diameter d2 of the opening 124 to the distance d1 is 1 : 2.92.

The filter 120 is disposed between the metal stacked layer 110 and the microlens 122. The filter 120 can be designed to be passed through by specific light waves with a specific wavelength. In a variant embodiment, the size of the opening 124 must be designed with considerations given to the filter 120 in order to optimize specific light waves.

In a variant embodiment, any metal layer other than the topmost metal layer 116 of the metal stacked layer 110 functions as a mask. For example, FIG. 4 is a cross-sectional view of an image sensor according to another embodiment of the present disclosure. The image sensor 200 of FIG. 4 is distinguished from the image sensor 100 of FIG. 1 in that the metal layer 216 under the topmost metal layer 220 of a metal stacked layer 210 functions as a mask. For example, the metal layer 216 is any metal layer other than the topmost metal layer 220 of the metal stacked layer 210. In the metal stacked layer 210, all the metal layers over and under the metal layer 216 must not block the light waves. For example, none of the metal layers over and under the metal layer 216 overlaps the opening 224 from a top view. In a variant embodiment, none of the metal layers over and under the metal layer 216 overlaps the light collection region 104.

FIG. 5 is a schematic view of the image sensor for use with a handheld device according to an embodiment of the present disclosure. The handheld device 500 includes a display assembly 400 and an image sensor 100/200. The handheld device 500 performs optical under-display fingerprint sensing to sense fingerprints of a specific subject. The handheld device 500 is a handheld electronic device, such as smartphone, PDA, handheld computer system or panel computer. FIG. 6 is a cross-sectional view of the handheld device shown in FIG. 5. Referring to FIG. 6, the display assembly 400 includes a display panel 402 and a protective cover 404. The protective cover 404 is disposed on the display panel 402. The image sensor 100/200 is disposed under the display panel 402. In this embodiment, the display panel 402 is an organic electroluminescence display (OLED) panel, but the present disclosure is not limited thereto. In a variant embodiment, the handheld device 500 further includes some other components, for example, a battery 406 disposed under the image sensor 100/200.

In the aforesaid embodiments, one of the metal layers of the metal stacked layer 110 functions as a mask, and part of the light waves passes through an opening on the metal layers, so as to reduce optical cross-talk. When applied to optical under-display fingerprint sensing technology, the image sensor of the present disclosure demonstrates enhanced capability to sense fingerprints without incurring additional costs.

## Claims

1. An image sensor(100, 200) comprising:
a substrate(102) doped to a first conductivity type, the substrate(102) having a front side and a back side, the back side being opposite to the front side;
a light collection region(104) disposed in the substrate(102) and neighboring the front side of the substrate(102), and arranged to collect photogenerated charge carriers, wherein the light collection region(104) is doped to a second conductivity type opposite to the first conductivity type;
a mask(116, 216) disposed over the substrate(102), and the mask(116, 216) having an opening(124, 224) allowing light waves to reach the light collection region(104) through the opening(124, 224) and be converted into the photogenerated charge carriers;
a plurality of metal layers(112, 116, 212, 216, 220) disposed over the front side of the substrate(102), and the mask(116, 216) being metal and being disposed in one of the plurality of metal layers(112, 116, 212, 216, 220); and
a plurality of inter-metal-layer dielectric layers(114, 118, 214, 218, 222) disposed between the metal layers(112, 116, 212, 216, 220) and corresponding to the metal layers(112, 116, 212, 216, 220), respectively, and the inter-metal-layer dielectric layer(118, 218) corresponding to the metal layer(116, 216) where the mask(116, 216) is disposed extending to the opening(124, 224) to fill the opening(124, 224),
**characterized in that**
the plurality of inter-metal-layer dielectric layers(114, 118, 214, 218, 222) include silicon oxide or silicon oxynitride; and **in that** a diameter(d2) of the opening(124, 224) is 2.36 to 3.45 times greater than a wavelength of the light waves being in the wavelength range from 526nm to 606nm, or a ratio of the diameter(d2) of the opening(124, 224) to a width of the light collection region(104) is 1:3.16 to 1:4.61, or a ratio of the diameter(d2) of the opening(124, 224) to the distance between the light collection region(104) and the opening(124, 224) is 1:2.92.

2. The image sensor of claim 1, wherein the mask(116, 216) is disposed in the topmost one of the metal layers(112, 116, 212, 216, 220).

3. The image sensor of claim 1, wherein the opening(124, 224) overlaps the light collection region(104) and does not extend beyond the light collection region(104).

4. The image sensor of claim 1, wherein the opening(124, 224) is in a round shape.

5. The image sensor of claim 4, wherein a center of the opening(124, 224) overlaps a center of the light collection region(104).

6. The image sensor of claim 1, wherein further comprising an isolation structure(106) disposed around the light collection region(104).

7. A handheld device(500), for sensing fingerprints of a specific subject, **characterized by** comprising:
a display assembly(400); and
the image sensor(100, 200) of any one of claims 1-6 for obtaining fingerprint information of the specific subject.

8. The handheld device of claim 7, wherein the display assembly(400) comprises a display panel(402) and a protective cover(404), the display panel(402) has a first side and a second side opposite to the first side, the protective cover(404) being disposed at the second side of the display panel(402), the image sensor(100, 200) being disposed at the first side of the display panel(402), and the display panel(402) being between the image sensor(100, 200) and the protective cover(404).

## Patentansprüche

1. Bildsensor (100, 200), aufweisend:
ein Substrat (102), welches auf einen ersten Leitfähigkeitstyp dotiert ist, wobei das Substrat (102) eine Vorderseite und eine Rückseite aufweist, wobei die Rückseite der Vorderseite gegenüberliegt;
eine lichtsammelnde Region (104), welche in dem Substrat (102) angeordnet und der Vorderseite des Substrats (102) benachbart ist und so eingerichtet ist, dass sie durch Licht erzeugte Ladungsträger sammelt, wobei die lichtsammelnde Region (104) auf einen zweiten Leitfähigkeitstyp dotiert ist, der dem ersten Leitfähigkeitstyp entgegengesetzt ist;
eine Maske (116, 216), welche über dem Substrat (102) angeordnet ist, wobei die Maske (116, 216) eine Öffnung (124, 224) aufweist, die ermöglicht, dass Lichtwellen durch die Öffnung (124, 224) hindurch die lichtsammelnde Region (104) erreichen und in die durch Licht erzeugten Ladungsträger umgewandelt werden;
mehrere Metallschichten (112, 116, 212, 216, 220), welche über der Vorderseite des Substrats (102) angeordnet sind, wobei es sich bei der Maske (116, 216) um Metall handelt und diese in einer der mehreren Metallschichten (112, 116, 212, 216, 220) angeordnet ist; und
mehrere Inter-Metallschicht-Dielektrikumsschichten (114, 118, 214, 218, 222), welche zwischen den Metallschichten (112, 116, 212, 216, 220) angeordnet sind und jeweils den Metallschichten (112, 116, 212, 216, 220) entsprechen, wobei sich die Inter-Metallschicht-Dielektrikumsschicht (118, 218), die der Metallschicht (116, 216) entspricht, wo die Maske (116, 216) angeordnet ist, bis zu der Öffnung (124, 224) erstreckt, um die Öffnung (124, 224) zu füllen,
**dadurch gekennzeichnet, dass**
die mehreren Inter-Metallschicht-Dielektrikumsschichten (114, 118, 214, 218, 222) Siliciumoxid oder Siliciumoxynitrid umfassen;
und dass ein Durchmesser (d2) der Öffnung (124, 224) 2,36- bis 3,45-mal größer ist als eine Wellenlänge der Lichtwellen, die in dem Wellenlängenbereich von 526 nm bis 606 nm liegen, oder ein Verhältnis des Durchmessers (d2) der Öffnung (124, 224) zu einer Breite der lichtsammelnden Region (104) 1:3,16 bis 1:4,61 beträgt oder ein Verhältnis des Durchmessers (d2) der Öffnung (124, 224) zu dem Abstand zwischen der lichtsammelnden Region (104) und der Öffnung (124, 224) 1:2,92 beträgt.

2. Bildsensor nach Anspruch 1, wobei die Maske (116, 216) in der obersten der Metallschichten (112, 116, 212, 216, 220) angeordnet ist.

3. Bildsensor nach Anspruch 1, wobei die Öffnung (124, 224) die lichtsammelnde Region (104) überdeckt und sich nicht über die lichtsammelnde Region (104) hinaus erstreckt.

4. Bildsensor nach Anspruch 1, wobei die Öffnung (124, 224) eine runde Form aufweist.

5. Bildsensor nach Anspruch 4, wobei eine Mitte der Öffnung (124, 224) eine Mitte der lichtsammelnden Region (104) überdeckt.

6. Bildsensor nach Anspruch 1, welcher ferner eine Isolationsstruktur (106) aufweist, die um die lichtsammelnde Region (104) herum angeordnet ist.

7. Handgerät (500) zum Erfassen von Fingerabdrücken eines speziellen Subjekts, **dadurch gekennzeichnet, dass** es aufweist:
eine Anzeigevorrichtungs-Baugruppe (400); und
den Bildsensor (100, 200) nach einem der Ansprüche 1 bis 6 zum Erhalten von Fingerabdruckinformationen des speziellen Subjekts.

8. Handgerät nach Anspruch 7, wobei die Anzeigevorrichtungs-Baugruppe (400) ein Anzeigefeld (402) und eine Schutzabdeckung (404) aufweist, das Anzeigefeld (402) eine erste Seite und eine zweite Seite gegenüber der ersten Seite aufweist, die Schutzabdeckung (404) auf der zweiten Seite des Anzeigefelds (402) angeordnet ist, der Bildsensor (100, 200) auf der ersten Seite des Anzeigefelds (402) angeordnet ist und sich das Anzeigefeld (402) zwischen dem Bildsensor (100, 200) und der Schutzabdeckung (404) befindet.

## Revendications

1. Capteur d'image (100, 200) comprenant :
un substrat (102) dopé à un premier type de conductivité, le substrat (102) comportant une face avant et une face arrière, la face arrière étant opposée à la face avant ;
une zone de collecte de lumière (104) disposée dans le substrat (102) et avoisinant la face avant du substrat (102) et agencée pour collecter des porteurs de charge photogénérés, dans lequel la zone de collecte de lumière (104) est dopé à un deuxième type de conductivité opposé au premier type de conductivité ;
un masque (116, 216) disposé sur le substrat (102) et le masque (116, 216) comportant une ouverture (124, 224) permettant aux ondes lumineuses d'atteindre la zone de collecte de lumière (104) à travers l'ouverture (124, 224) et d'être converties en porteurs de charge photogénérés ;
une pluralité de couches métalliques (112, 116, 212, 216, 220) disposées sur la face avant du substrat (102) et le masque (116, 216) étant en métal et étant disposé dans une de la pluralité de couches métalliques (112, 116, 212, 216, 220) ; et
une pluralité de couches diélectriques à couche intermétallique (114, 118, 214, 218, 222) disposées entre les couches métalliques (112, 116, 212, 216, 220) et correspondant aux couches métalliques (112, 116, 212, 216, 220) respectivement et la couche diélectrique à couche intermétallique (118, 218) correspondant à la couche métal (116, 216) où le masque (116, 216) est disposée en s'étendant vers l'ouverture (124, 224) afin de remplir l'ouverture (124, 224),
**caractérisé en ce que** la pluralité de couches diélectriques à couches intermétalliques (114, 118, 214, 218, 222) comprend de l'oxyde de silicium ou de l'oxynitrure de silicium ;
et **en ce que** le diamètre (d2) de l'ouverture (124, 224) est 2.36 à 3.45 fois plus grand qu'une longueur d'onde des ondes lumineuses étant dans la plage de longueur d'onde de 526nm à 606nm ou un rapport du diamètre (d2) de l'ouverture (124, 224) à une largeur de la zone de collecte de lumière (104) est 1 :3 :16 à 1 :4 :61 ou un rapport du diamètre (d2) de l'ouverture (124, 224) à la distance entre la zone de collecte de lumière (104) et l'ouverture (124, 224) est 1 :2 :92.

2. Capteur d'image selon la revendication 1, dans lequel le masque (116, 216) est disposée dans la couche la plus haute des couches métalliques (112, 116, 212, 216, 220) .

3. Capteur d'image selon la revendication 1, dans lequel l'ouverture (124, 224) enveloppe la zone de collecte lumineuse (104) et ne s'étend pas au-delà de la zone de collecte de lumière (104).

4. Capteur d'image selon la revendication 1, dans lequel l'ouverture (124, 224) est de forme arrondie.

5. Capteur d'image selon la revendication 4, dans lequel un centre de l'ouverture (124, 224) se superpose à un centre de la zone de collecte de lumière (104).

6. Capteur d'image selon la revendication 1, comprenant en outre une structure d'isolation (106) disposée autour de la zone de collecte de lumière (104).

7. Dispositif portatif (500) pour détecter des empreintes digitales d'un sujet spécifique, **caractérisé en ce qu'**il comprend :
un ensemble d'affichage (400) ; et
le capteur d'image (100, 200) selon une quelconque des revendications 1 à 6 pour obtenir des informations d'empreintes digitales du sujet spécifique.

8. Dispositif portatif selon la revendication 7, dans lequel l'ensemble d'affichage (400) comprend un panneau d'affichage (402) et un couvercle protecteur (404), le panneau d'affichage (402) possède une première face et une deuxième face opposée à la première face, le couvercle protecteur (404) étant disposé au niveau de la deuxième face du panneau d'affichage (402), le capteur d'image (100, 200) étant disposé au niveau de la première face du panneau d'affichage (402) et le panneau d'affichage (402) étant intercalé entre le capteur d'image (100, 200) et le couvercle protecteur (404).
